# EUROPEAN PATENT APPLICATION

(11) **EP 2 408 007 A2**
(43) Date of publication of application: **18.01.2012**
(21) Application number: 11172394.6
(22) Date of filing: 01.07.2011
(51) Int. Cl.: H01L 21/8234, H01L 21/761, H01L 27/06, H01L 27/02

(54) **Semiconductor integrated circuit device**

(30) Priority: 13.07.2010 JP 2010158895
(71) Applicant: Mitsumi Electric Co., Ltd., Tama-shi, Tokyo 206-8567 (JP)
(72) Inventor: Inoue, Fumihiro, Tokyo 206-8567 (JP)
(74) Representative: TER MEER - STEINMEISTER & PARTNER GbR

(57) **Abstract**

A semiconductor integrated circuit device includes a semiconductor substrate including a digital circuit area (13) and an analog circuit area (12) that is divided into an active element area (12a) disposed away from the digital circuit area and a passive element area (12b,c) disposed adjacent to the digital circuit area; a first well (21) having a first conductivity type that is different from a second conductivity type of the semiconductor substrate (20) and formed in a part of the semiconductor substrate corresponding to the passive element area; a second well (22) having the second conductivity type and formed in the first well; a device isolation film (23) formed on the second well; a digital circuit formed in the digital circuit area; an active element implemented by an analog circuit and formed in the active element area; and a passive element (25,26) implemented by an analog circuit and formed on the device isolation film in the passive element area.

## Description

### BACKGROUND OF THE INVENTION

### 1. Field of the Invention

A certain aspect of this disclosure relates to a semiconductor integrated circuit device.

### 2. Description of the Related Art

Currently, battery packs including lithium ion batteries are commonly used for portable devices such as digital cameras. One problem in using a lithium ion battery is that it is generally difficult to measure the remaining charge (energy) level based on its voltage. For this reason, the remaining charge level of a lithium ion battery is calculated, for example, by measuring and totaling the amounts of charge-and-discharge currents of the lithium ion battery with a microprocessor.

For example, a battery monitor IC for measuring the remaining charge level of a battery includes analog circuits such as a high-resolution A/D converter and digital circuits such as a timer and a CPU for totaling the measured amounts of electric currents, and is implemented as a one-chip semiconductor integrated circuit device where the analog and digital circuits are integrated on one chip.

In the digital circuits of such a one-chip semiconductor integrated circuit device, noise associated with, for example, charge-and-discharge currents, through currents, and harmonic components, is generated in synchronization with clock signals. The noise generated in the digital circuits is transmitted via a semiconductor substrate of the one-chip semiconductor integrated circuit device to the analog circuits including a high-resolution A/D converter and reduces the accuracy of A/D conversion.

Meanwhile, along with the downsizing of battery packs, it is desired to reduce the size of battery monitor ICs. However, reducing the size of a battery monitor IC increases the influence of noise and makes it difficult to include a circuit or an electronic part for noise reduction in the battery monitor IC. This is a problem not only for battery monitor ICs, but also for any semiconductor integrated circuit device including both an analog circuit and a digital circuit.

The applicant has proposed a semiconductor integrated circuit device including a digital circuit area where digital circuits are formed and an analog circuit area where analog circuits are formed (see Japanese Laid-Open Patent Publication No. 2010-123736). In the proposed semiconductor integrated circuit device, the analog circuit area is divided into an active element area where an active element implemented by an analog circuit is formed and a passive element area where a resistor or a capacitor implemented by an analog circuit is formed. Also in the proposed semiconductor integrated circuit device, the passive element area is disposed adjacent to the digital circuit area and the active element area is disposed away from the digital circuit area.

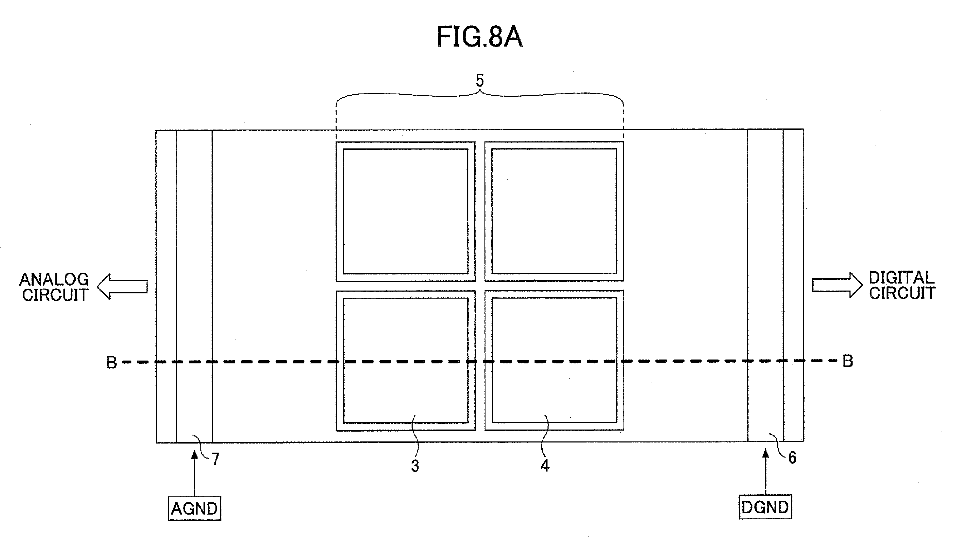

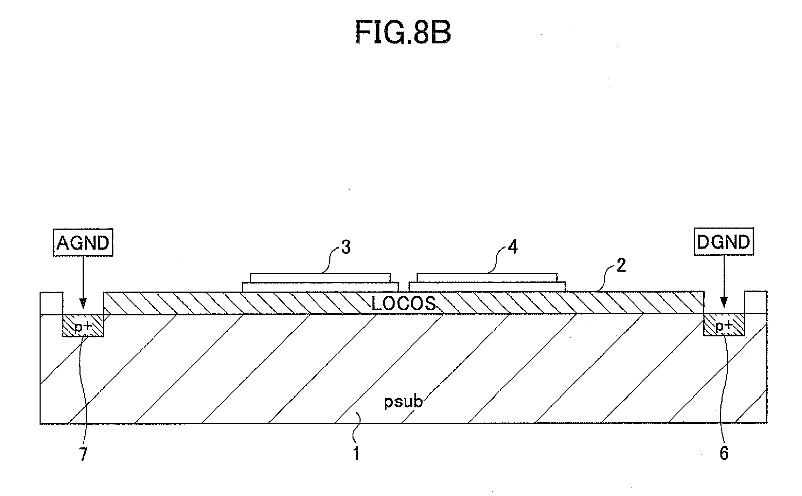

FIG. 8A is a plan view of a part of a related-art semiconductor integrated circuit device, and FIG. 8B is a cross-sectional view of the semiconductor integrated circuit device of FIG. 8A taken along line B-B. As illustrated in FIGs. 8A and 8B, the semiconductor integrated circuit device includes a p-type semiconductor substrate 1, a device isolation film 2 called local oxidation of silicon (LOCOS), and passive elements 3 and 4 such as resistors or capacitors formed on the device isolation film 2 in a passive element area 5 of an analog circuit area.

The passive element area 5 is disposed to the left of a digital circuit area and to the right of an active element area of the analog circuit area. A p⁺-type layer 6 is formed in the semiconductor substrate 1 between the passive element area 5 and the digital circuit area. A ground voltage DGND for digital circuits is supplied to the p⁺-type layer 6. A p⁺-type layer 7 is formed in the semiconductor substrate 1 between the passive element area 5 and the active element area of the analog circuit area. A ground voltage AGND for analog circuits is supplied to the p⁺-type layer 7.

With the configuration of FIGs. 8A and 8B where the passive element area 5 is disposed between the digital circuit area and the active element area of the analog circuit area, noise generated in the digital circuits is transmitted through the semiconductor substrate 1 in the passive element area 5 and attenuated by the resistance of the semiconductor substrate 1 before reaching the active element area of the analog circuit area. Accordingly, with this configuration, noise transmitted from the digital circuits to the analog circuits can be more effectively reduced by increasing the distance between the digital circuit area and the active element area of the analog circuit area.

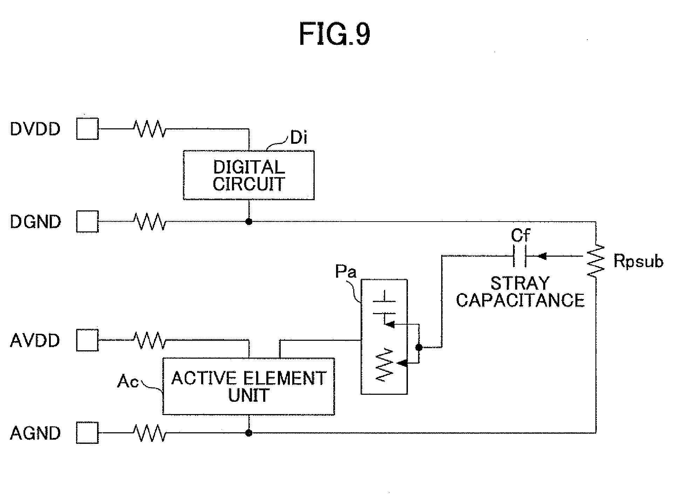

Here, it is necessary to consider stray capacitance that is present between the semiconductor substrate 1 and the passive elements 3 and 4 in the passive element area 5. For example, when the passive elements 3 and 4 are capacitors, the value of the stray capacitance is about 1/20 of the capacitance of the capacitors. FIG. 9 is an equivalent circuit schematic of a related-art semiconductor integrated circuit device. In FIG. 9, a digital circuit Di corresponds to the digital circuits in the digital circuit area, an active element unit Ac corresponds to active elements in the active element area, a passive element unit Pa corresponds to the passive elements 3 and 4 in the passive element area 5, Rpsub indicates resistance formed by the semiconductor substrate 1 in the passive element area 5, and Cf indicates stray capacitance formed by the device isolation film (LOCOS) 2 between the semiconductor substrate 1 and the passive elements 3 and 4 in the passive element area 5. The digital circuit Di is connected via the resistance Rpsub to the active element unit Ac, and the resistance Rpsub is connected via the stray capacitance Cf to the passive element unit Pa. Needless to say, the active element unit Ac and the passive element unit Pa are connected to each other via wire.

With this configuration, noise generated in the digital circuit Di is transmitted to the semiconductor substrate 1 in the passive element area 5 and enters the passive elements 3 and 5 (the passive element unit Pa) via the stray capacitance Cf. Thus, with the related-art configuration, it is difficult to sufficiently reduce noise entering analog circuits.

### SUMMARY OF THE INVENTION

According to an aspect of this disclosure, a semiconductor integrated circuit device includes a semiconductor substrate including a digital circuit area and an analog circuit area that is divided into an active element area disposed away from the digital circuit area and a passive element area disposed adjacent to the digital circuit area; a first well having a first conductivity type that is different from a second conductivity type of the semiconductor substrate and formed in a part of the semiconductor substrate corresponding to the passive element area; a second well having the second conductivity type and formed in the first well; a device isolation film formed on the second well; a digital circuit formed in the digital circuit area; an active element implemented by an analog circuit and formed in the active element area; and a passive element implemented by an analog circuit and formed on the device isolation film in the passive element area.

### BRIEF DESCRIPTION OF THE DRAWINGS

FIG. 1 is a drawing illustrating an exemplary configuration of a semiconductor integrated circuit device according to an embodiment;
FIG. 2A is a plan view of a part of a semiconductor integrated circuit device according to an embodiment;
FIG. 2B is a cross-sectional view of the semiconductor integrated circuit device of FIG. 2A taken along line A-A;
FIG. 3 is an equivalent circuit schematic of a semiconductor integrated circuit device according to an embodiment;
FIG. 4A is a cut-away side view of a part of a semiconductor integrated circuit device according to an embodiment;
FIG. 4B is an equivalent circuit schematic of the semiconductor integrated circuit device of FIG. 4A;
FIG. 5 is a block diagram illustrating an exemplary configuration of a phase-locked loop;
FIG. 6 is a circuit diagram illustrating an exemplary configuration of a delta-sigma modulator;
FIG. 7 is a block diagram illustrating an exemplary configuration of a battery pack including a battery monitor IC;
FIG. 8A is a plan view of a part of a related-art semiconductor integrated circuit device;
FIG. 8B is a cross-sectional view of the semiconductor integrated circuit device of FIG. 8A taken along line B-B; and
FIG. 9 is an equivalent circuit schematic of a related-art semiconductor integrated circuit device.

### DESCRIPTION OF THE PREFERRED EMBODIMENTS

Preferred embodiments of the present invention are described below with reference to the accompanying drawings.

### <SEMICONDUCTOR INTEGRATED CIRCUIT DEVICE>

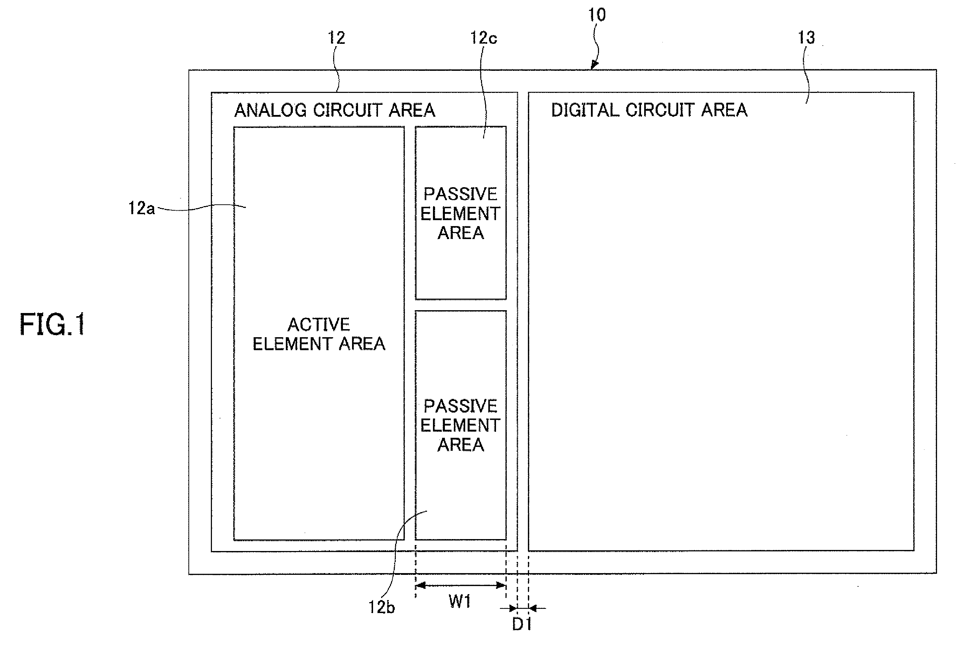

FIG. 1 is a drawing illustrating an exemplary configuration of a semiconductor integrated circuit device 10 according to an embodiment. As illustrated in FIG. 1, the semiconductor integrated circuit device 10 includes an analog circuit area 12 and a digital circuit area 13. The analog circuit area 12 and the digital circuit area 13 are separated from each other by a distance D1.

For example, the semiconductor integrated circuit device 10 may be configured as a battery monitor IC. In this case, analog circuits such as a delta-sigma modulator, an oscillating circuit including a phase-locked loop (PLL), and sensors may be formed in the analog circuit area 12; and digital circuits such as a CPU, memories (e.g., a RAM and a ROM), a register, and a communication circuit may be formed in the digital circuit area 13.

The analog circuit area 12 may be divided into an active element area 12a where active elements such as MOS transistors are formed, a passive element area 12b where passive elements such as capacitors are formed, and a passive element area 12c where passive elements such as resistors are formed. Alternatively, the capacitors and the resistors may be formed in one passive element area. The passive element areas 12b and 12c may have a width W1 of several tens to several hundred µm. For example, the width W1 is 200 µm.

In the active element area 12a, MOS transistors constituting parts of the delta-sigma modulator, the PLL, and the sensors may be formed. In the passive element area 12b, high-capacitance capacitors constituting parts of the delta-sigma modulator and the PLL may be formed. In the passive element area 12c, high-resistance resistors constituting parts of the delta-sigma modulator and the PLL may be formed.

The passive element area 12b and the passive element area 12c are disposed in a part of the analog circuit area 12 that is adjacent to the digital circuit area 13. The active element area 12a is disposed in a part of the analog circuit area 12 that is away from the digital circuit area 13 (i.e., the active element area 12a is further from the digital circuit area 13 than the passive element area 12b).

### <PASSIVE ELEMENT AREA>

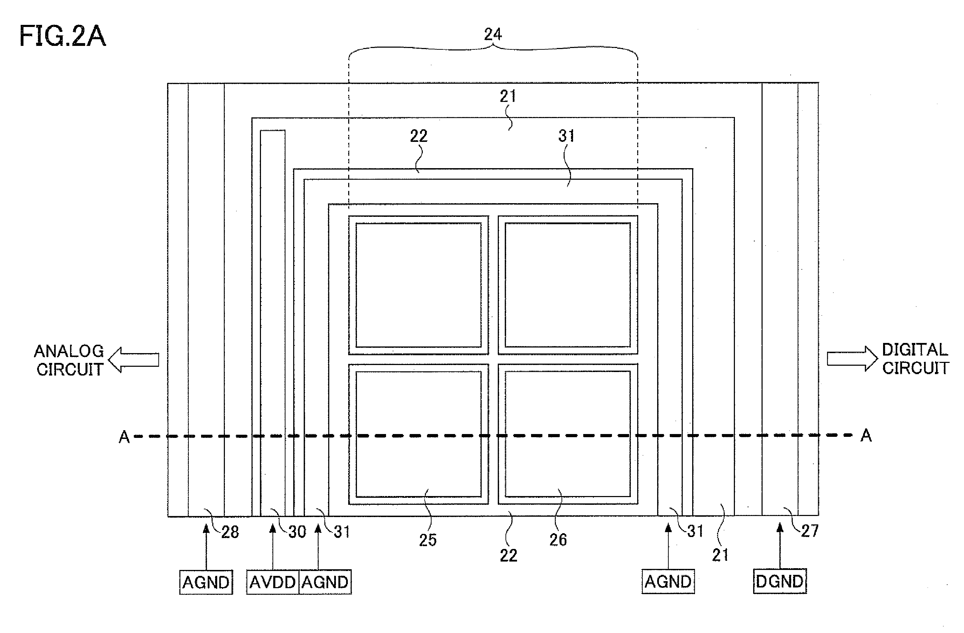

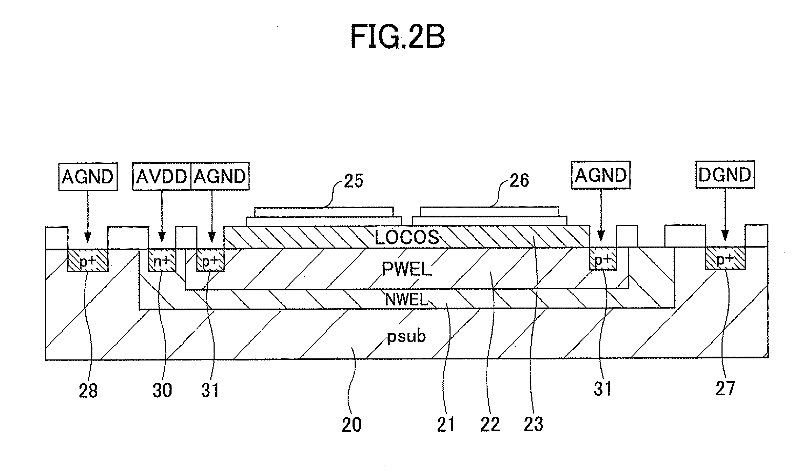

FIG. 2A is a plan view of a part of a semiconductor integrated circuit device of this embodiment, and FIG. 2B is a cross-sectional view of the semiconductor integrated circuit device of FIG. 2A taken along line A-A. As illustrated in FIGs. 2A and 2B, the semiconductor integrated circuit device includes a p-type semiconductor substrate 20. An n-type well (NWEL) 21 is formed in a part of the semiconductor substrate 20 and a p-type well (PWEL) 22 is formed in the n-type well 21. A device isolation film (LOCOS) 23 implementing a passive element area 24 is formed on the p-type well 22. The passive element area 24 corresponds to the passive element areas 12b and 12c of FIG. 1. Here, the entire area between the digital circuit area and the active element area may also be called a passive element area. Passive elements 25 and 26 such as resistors and capacitors are formed on the device isolation film 23 in the passive element area 24.

The passive element area 24 is disposed to the left of the digital circuit area 13 and to the right of the active element area 12a of the analog circuit area 12. A p⁺-type layer 27, which is a highly-doped p-type layer, is formed in the semiconductor substrate 20 between the passive element area 24 and the digital circuit area 13. A ground voltage DGND for the digital circuits is supplied to the p⁺-type layer 27. A p⁺-type layer 28 is formed in the semiconductor substrate 20 between the passive element area 24 and the active element area 12a. A ground voltage AGND for the analog circuits is supplied to the p⁺-type layer 28.

An n⁺-type layer 30, which is a highly-doped n-type layer, is formed in a part of the n-type well 21 adjacent to the active element area 12a. A supply voltage AVDD (AVDD > AGND) for the analog circuits is supplied to the n⁺-type layer 30. Although the n⁺-type layer 30 of this embodiment extends parallel to the p⁺-type layer 28, the shape of the n⁺-type layer 30 is not limited to that illustrated in FIG. 2A. For example, one end of the n⁺-type layer 30 may extend further toward the digital circuit area 13. Still, however, the n⁺-type layer 30 is not formed in an area adjacent to the digital circuit area 13. This configuration makes it possible to prevent noise generated in the digital circuit area 13 from entering the supply voltage AVDD via the n⁺-type layer 30.

A p⁺-type layer 31 is formed on the periphery of the p-type well 22 to surround the passive elements 25 and 26. A ground voltage AGND for the analog circuits is supplied to the p⁺-type layer 31. Here, it is not essential to shape the p⁺-type layer 31 to surround the passive elements 25 and 26.

With the above configuration, the supply voltage AVDD for the analog circuits is supplied to the n-type well 21, the ground voltage AGND for the analog circuits and the ground voltage DGND for the digital circuits are supplied to the p-type semiconductor substrate 20, and the ground voltage AGND is supplied to the p-type well 22. As a result, a reverse bias is applied to the PN junction between the p-type semiconductor substrate 20 and the n-type well 21 and a reverse bias is also applied to the PN junction between the n-type well 21 and the p-type well 22. This in turn makes it possible to increase depletion layers at the PN junctions and thereby makes it possible to reduce the stray capacitance between the p-type semiconductor substrate 20 and the n-type well 21 and the stray capacitance between the n-type well 21 and the p-type well 22. In other words, the above configuration makes it possible to reduce the stray capacitance between the p-type semiconductor substrate 20 and the passive elements 25 and 26.

### <EQUIVALENT CIRCUIT>

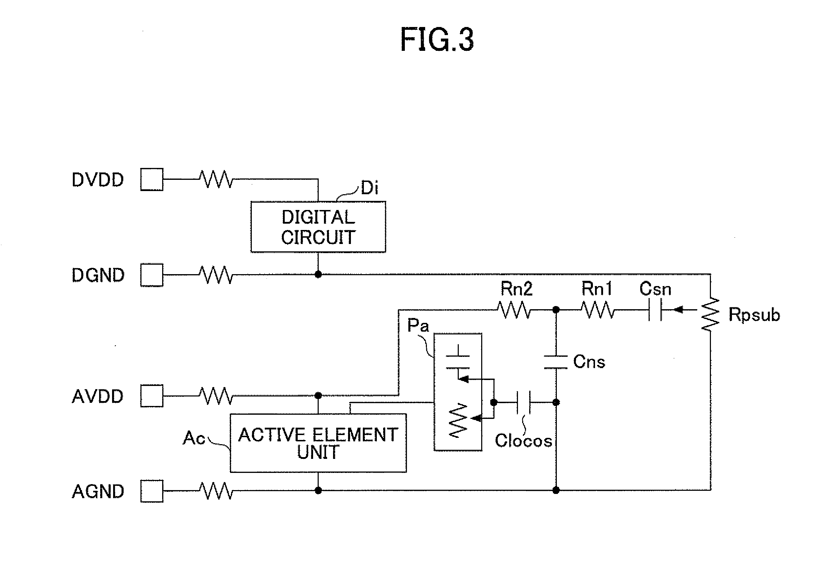

FIG. 3 is an equivalent circuit schematic of a semiconductor integrated circuit device of this embodiment. In FIG. 3, a digital circuit Di corresponds to the digital circuits in the digital circuit area 13, an active element unit Ac corresponds to the active elements in the active element area 12a, a passive element unit Pa corresponds to the passive elements 25 and 26 in the passive element area 24, Rpsub indicates resistance formed by the semiconductor substrate 20 in the passive element area 24, Csn indicates the stray capacitance between the semiconductor substrate 20 and the n-type well 21 in the passive element area 24, Rn1 and Rn2 indicate resistance formed by the n-type well 21, Cns indicates the stray capacitance between the n-type well 21 and the p-type well 22, and Clocos indicates the stray capacitance of the device isolation film (LOCOS) 23. The digital circuit Di is connected via the resistance Rpsub to the active element unit Ac. The resistance Rpsub is connected via the stray capacitance Csn and the resistance Rn1 and Rn2 to the active element unit Ac and a power supply supplying the supply voltage AVDD to the analog circuits. The n-type well 21 (the node between the resistance Rn1 and the resistance Rn2) is connected via the stray capacitance Cns to a power supply supplying the ground voltage AGND for the analog circuits, and is also connected via the stray capacitance Clocos to the passive element unit Pa. Needless to say, the active element unit Ac and the passive element unit Pa are connected to each other via wire.

With the above configuration, even if noise from the digital circuit area 13 enters the semiconductor substrate 20 and then enters the n-type well 21 via the stray capacitance Csn, the noise is attenuated by the resistance Rn1 and Rn2 of the n-type well 21. Accordingly, the above configuration makes it possible to prevent or reduce the noise entering the supply voltage AVDD and the active element unit Ac. Also with the above configuration, reverse biases are applied to the PN junctions between the n-type well 21, the p-type semiconductor substrate 20, and the p-type well 22. This in turn makes it possible to reduce the stray capacitance Csn and Cns and thereby makes it possible to prevent or reduce the noise entering the n-type well 21 via the semiconductor substrate 20 and to prevent or reduce the noise entering the passive elements 25 and 26 via the n-type well 21, the p-type well 22, and the device isolation film (LOCOS) 23. Thus, the above configuration makes it possible to effectively prevent noise generated in a digital circuit from entering and influencing an analog circuit.

### <LATCH-UP>

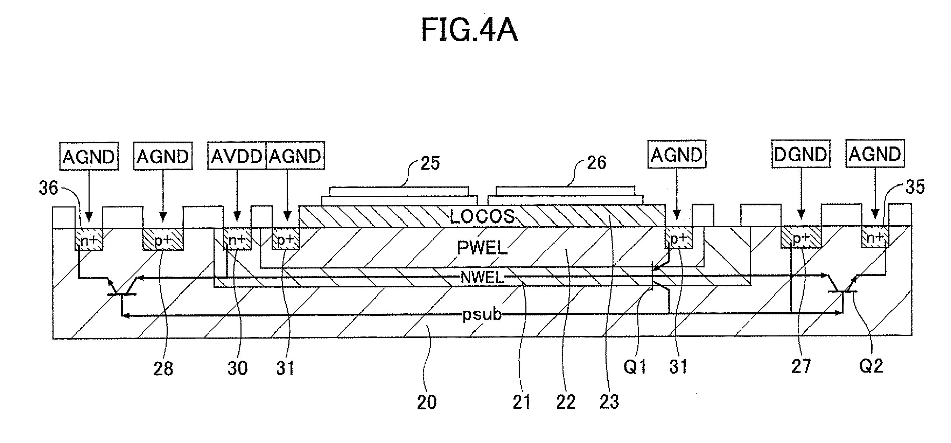

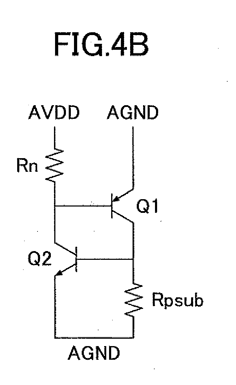

FIG. 4A is a cut-away side view of a part of a semiconductor integrated circuit device of this embodiment, FIG. 4B is an equivalent circuit schematic of the semiconductor integrated circuit device of FIG. 4A. In FIGs. 4A and 4B, it is assumed that a PNP transistor Q1 is formed by the p-type semiconductor substrate 20, the n-type well 21, and the p-type well 22; and an NPN transistor Q2 is formed by the n-type well 21, the p-type semiconductor substrate 20, and an n-type well (or n-type layer) 35 or 36 formed in the p-type semiconductor substrate 20.

As illustrated in FIG. 4B, the transistors Q1 and Q2 form a thyristor (thyristor structure). In FIG. 4B, the ground voltage AGND for the analog circuits is supplied to the emitter of the transistor Q1, and the supply voltage AVDD for the analog circuits is supplied to the base of the transistor Q1 and the collector of the transistor Q2 via the resistance Rn of the n-type well 21. Also, the ground voltage AGND for the analog circuits is supplied via the resistance Rpsub formed by the p-type semiconductor substrate 20 to the collector of the transistor Q1 and the base of the transistor Q2, and is also supplied to the emitter of the transistor Q2.

With this configuration, when both the transistors Q1 and Q2 are turned on due to, for example, noise, latch-up may occur in the thyristor. However, this does not cause any substantial problem because only the ground voltage AGND of the emitter of the transistor Q1 and the ground voltage AGND of the emitter of the transistor Q2 are connected to each other and no current actually flows.

### <PASSIVE ELEMENTS>

The passive elements 25 and 26 are described below. Assuming that the passive element 25 is a capacitor (capacitative element), the passive element 25 may include a first metal wiring layer and a second metal wiring layer that are disposed to face each other via an insulating layer such as an oxide film. The first and second metal wiring layers may be replaced with, for example, polysilicon wiring layers. Assuming that the passive element 26 is a resistor (resistance element), the passive element 26 may include an insulating layer such as an oxide film and a polysilicon wiring layer that shows resistance and is provided in the insulating layer.

### <PHASE-LOCKED LOOP (PLL)>

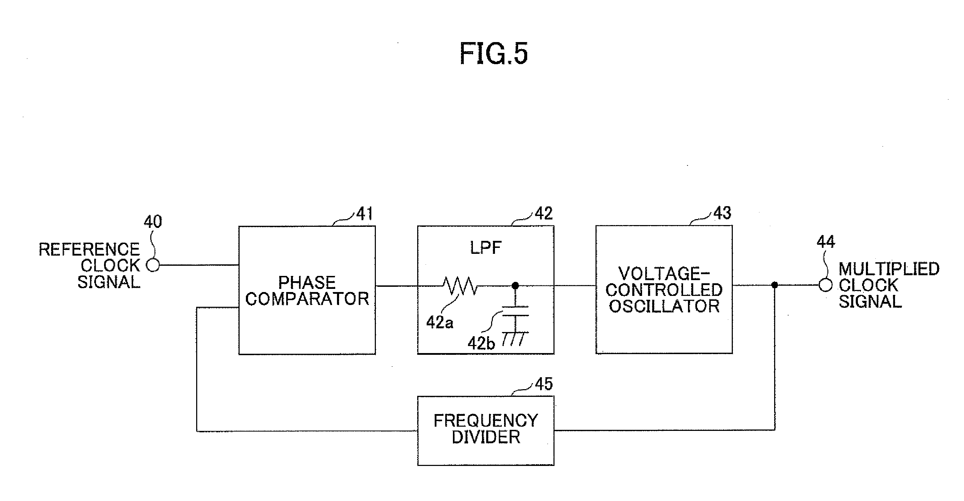

FIG. 5 is a block diagram illustrating an exemplary configuration of a phase-locked loop (PLL) of this embodiment. The PLL may include a terminal 40, a phase comparator 41, a low-pass filter (LPF) 42, a voltage control oscillator (VCO) 43, a terminal 44, and a frequency divider 45. A reference clock signal generated by an oscillator is supplied via the terminal 40 to the phase comparator 41. The phase comparator 41 compares the phases of the reference clock signal and a frequency-divided clock signal supplied from the frequency divider 45 and outputs a phase difference signal to the low-pass filter 42.

The low-pass filter 42 removes an unnecessary frequency component(s) from the phase difference signal and outputs the resulting phase difference signal to the voltage control oscillator 43. The low-pass filter 42 has a low cut-off frequency and includes a high-resistance resistor 42a and a high-capacitance capacitor 42b.

The voltage control oscillator 43 varies the oscillating frequency according to the phase difference signal and outputs an oscillating frequency signal. The oscillating frequency signal is output as a multiplied clock signal to the terminal 44 and the frequency divider 45. The frequency divider 45 divides the frequency of the multiplied clock signal and outputs a frequency-divided clock signal to the phase comparator 41.

The phase comparator 41, the voltage control oscillator 43, and the frequency divider 45 may be formed in the active element area 12a of the analog circuit area 12; the resistor 42a of the low-pass filter 42 may be formed in the passive element area 12c, and the capacitor 42b of the low-pass filter 42 may be formed in the passive element area 12b.

### <DELTA-SIGMA MODULATOR>

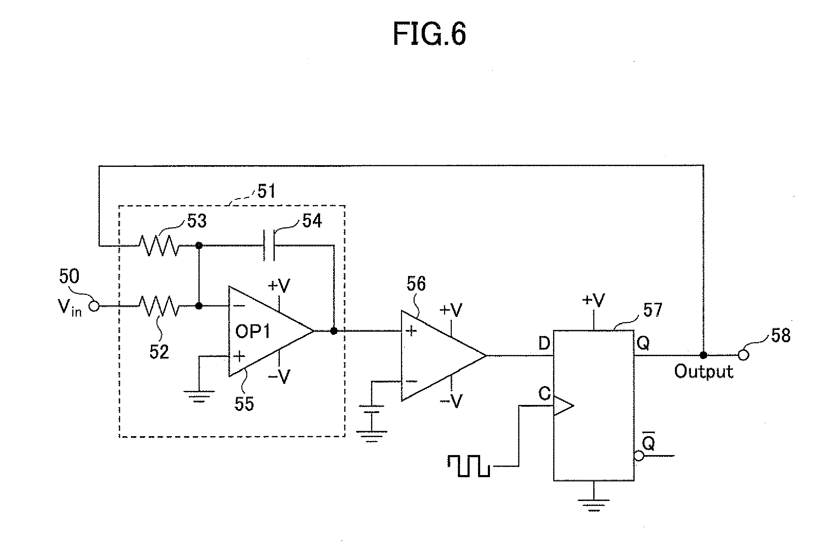

FIG. 6 is a block diagram illustrating an exemplary configuration of a delta-sigma modulator of this embodiment.

The delta-sigma modulator may include a terminal 50, an integrating circuit 51, a comparator 56, a D-type flip-flop, and a terminal 58. An analog voltage Vin is supplied via the terminal 50 to the integrating circuit 51. The integrating circuit 51 includes an input resistor 52 and a feedback resistor 53 having high resistance, an integrating capacitor 54 having high capacitance, and an operational amplifier 55.

An output signal from the integrating circuit 51 is quantized by the comparator 56, delayed by one clock (cycle) by the D-type flip-flop 57, and output from the terminal 58. The output signal at the terminal 58 is also supplied to the feedback resistor 53. The feedback resistor 53 substantially performs 1-bit digital-to-analog conversion on the output signal. Then, in the integrating circuit 51, the converted signal is added to or subtracted from the analog voltage Vin.

The operational amplifier 55, the comparator 56, and the D-type flip-flop 57 may be formed in the active element area 12a of the analog circuit area 12; the input resistor 52 and the feedback resistor 53 may be formed in the passive element area 12c; and the integrating capacitor 54 may be formed in the passive element area 12b.

### <BATTERY PACK>

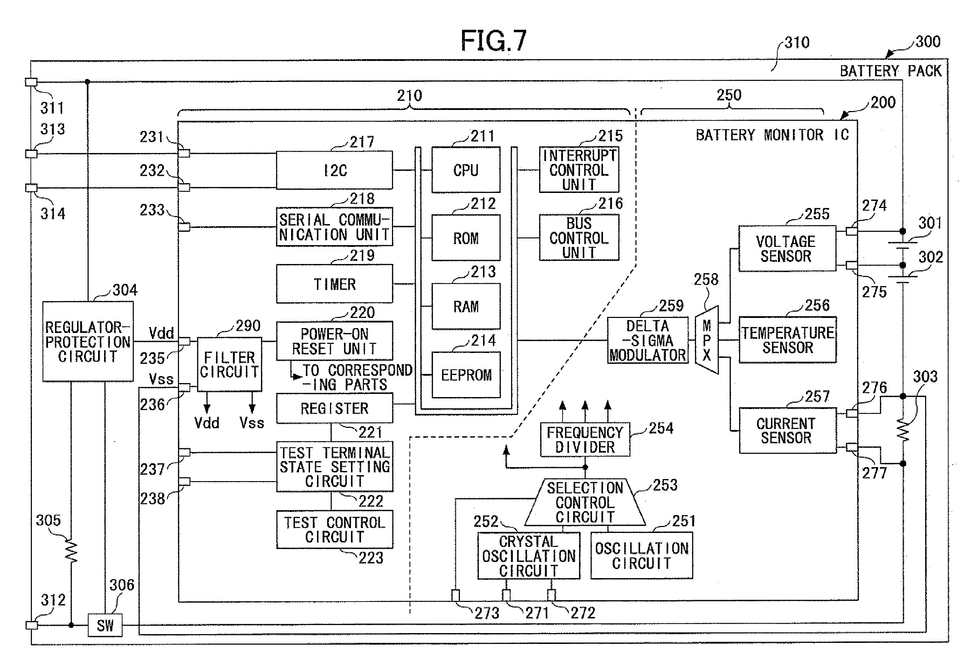

FIG. 7 is a block diagram illustrating an exemplary configuration of a battery pack 300 including a battery monitor IC 200 of this embodiment. The battery monitor IC 200 is an example of the semiconductor integrated circuit device 10 of this embodiment and includes a digital unit 210 and an analog unit 250.

The digital unit 210 corresponds to the digital circuit area 13 of FIG. 1 and the analog unit 250 corresponds to the analog circuit area 12 of FIG. 1.

The digital unit 210 includes a CPU 211, a ROM 212, a RAM 213, an EEPROM 214, an interrupt control unit 215, a bus control unit 216, an I2C unit 217, a serial communication unit 218, a timer 219, a power-on reset unit 220, a register 221, a test terminal state setting circuit 222, a test control circuit 223, and a filter circuit 290. The CPU 211, the ROM 212, the RAM 213, the EEPROM 214, the interrupt control unit 215, the bus control unit 216, the I2C unit 217, the serial communication unit 218, the timer 219, and the register 221 are connected to each other via an internal bus.

The CPU 211, for example, executes a program stored in the ROM 212 and thereby controls the battery monitor IC 200 and also calculates the remaining charge level of a battery by totaling the amounts of charge-and-discharge currents of the battery. The RAM 213 is used by the CPU 211 as a work area. The EEPROM 214 stores, for example, trimming information.

The interrupt control unit 215 receives interrupt requests from other components of the battery monitor IC 200, generates interrupt signals according to the priorities of the interrupt requests, and sends the interrupt signals to the CPU 211. The bus control unit 216 assigns the internal bus to the respective circuits.

The I2C unit 217 is connected via ports 231 and 232 to a communication line and performs two-wire serial communications. The serial communication unit 218 is connected via a port 233 to a communication line (not shown) and performs single-wire serial communications.

The timer 219 counts system clock cycles to obtain a system clock count that is referred to by the CPU 211. The power-on reset unit 220 detects a rise of a supply voltage Vdd supplied to a port 235 connected to the power-on reset unit 220 via the filter circuit 290, generates a reset signal, and sends the reset signal to the corresponding components of the battery monitor IC 200.

The register 221 retains information transferred from the EEPROM 214. The test terminal state setting circuit 222 connects test terminals 237 and 238 with the test control circuit 223 according to the information retained in the register 221 and sets the levels of input signals from the test terminals 237 and 238 to predetermined values.

When receiving the input signals from the test terminals 237 and 238 via the test terminal state setting circuit 222, the test control circuit 223 changes the states of internal circuits of the battery monitor IC 200 according to the input signals to perform tests on the internal circuits.

The analog unit 250 includes an oscillation circuit 251, a crystal oscillation circuit 252, a selection control circuit 253, a frequency divider 254, a voltage sensor 255, a temperature sensor 256, a current sensor 257, a multiplexer 258, and a delta-sigma modulator 259.

The oscillation circuit 251 is an oscillator including a PLL and outputs an oscillation signal with a frequency of several MHz. The crystal oscillation circuit 252 generates and outputs an oscillation signal with a frequency of several MHz using an external crystal oscillator connected to ports 271 and 272. The accuracy of the oscillating frequency of the crystal oscillation circuit 252 is higher than that of the oscillation circuit 251.

The selection control circuit 253 selects one of the oscillation signals output from the oscillation circuit 251 and the crystal oscillation circuit 252 according to a selection signal supplied from a port 273 and supplies the selected oscillation signal as a system clock signal to the frequency divider 254 and other components of the battery monitor IC 200. The selection control circuit 253 also generates a reset signal RST and a control signal CNT. The selection control circuit 253 may be configured to select the oscillation signal from the oscillation circuit 251 when no selection signal is supplied from the port 273. The frequency divider 254 divides the frequency of the system clock signal, thereby generates various clock signals, and supplies the generated clock signals to the corresponding components of the battery monitor IC 200.

The voltage sensor 255 detects voltages of batteries 301 and 302 connected to ports 274 and 275 and supplies the detected voltages as analog voltage signals to the multiplexer 258. The temperature sensor 256 detects an environmental temperature of the battery monitor IC 200 and supplies the detected temperature as an analog temperature signal to the multiplexer 258.

Ports 276 and 277 are connected to the corresponding ends of a resistor 303 used for electric current detection. The current sensor 257 detects an electric current passing through the resistor 303 based on the potential difference between the ports 276 and 277 and supplies the detected electric current as an analog current signal to the multiplexer 258.

The multiplexer 258 selects and supplies the analog voltage signals, the analog temperature signal, and the analog current signal in sequence to the delta-sigma modulator 259. The delta-sigma modulator 259 performs delta-sigma conversion on the analog signals to obtain pulse density modulation signals and supplies the obtained pulse density modulation signals via the internal bus to the CPU 211. The CPU 211 performs digital filtering on the pulse density modulation signals and thereby digitizes the analog voltage signals, the analog temperature signal, and the analog current signal. The CPU 211 also calculates the remaining charge levels of the batteries 301 and 302 by totaling the amounts of charge-and-discharge currents of the batteries 301 and 302. In the calculation, the detected temperature is used for temperature correction.

The battery monitor IC 200, the batteries 301 and 302, the resistor 303 for electric current detection, a regulator-protection circuit 304, a resistor 305, and a switch 306 are housed in a case 310 to form the battery pack 300. A terminal 311 of the battery pack 300 is connected to the positive terminal of the battery 301 and a power input terminal of the regulator-protection circuit 304. A power output terminal of the regulator-protection circuit 304 is connected to the port 235 for the supply voltage Vdd of the battery monitor IC 200. A terminal 312 is connected via the resistor 305 to a ground terminal of the regulator-protection circuit 304 and is also connected via the switch 306 to the node between the resistor 303 and the port 277. The regulator-protection circuit 304 regulates the voltage between the terminals 311 and 312 and protects the battery monitor IC 200 by opening the switch 306 when the voltage exceeds a predetermined level.

A port 236 for a supply voltage Vss of the battery monitor IC 200 is connected to the node between the resistor 303 and the port 276. Terminals 313 and 314 of the battery pack 300 are connected to the ports 231 and 232 of the battery monitor IC 200.

As described above, an aspect of this disclosure makes it possible to provide a semiconductor integrated circuit device where noise generated in a digital circuit is effectively prevented from entering an analog circuit.

The present invention is not limited to the specifically disclosed embodiments, and variations and modifications may be made without departing from the scope of the present invention.

## Claims

1. A semiconductor integrated circuit device, comprising:
a semiconductor substrate including a digital circuit area and an analog circuit area, wherein the analog circuit area is divided into an active element area disposed away from the digital circuit area and a passive element area disposed adjacent to the digital circuit area;
a first well having a first conductivity type that is different from a second conductivity type of the semiconductor substrate and formed in a part of the semiconductor substrate corresponding to the passive element area;
a second well having the second conductivity type and formed in the first well;
a device isolation film formed on the second well;
a digital circuit formed in the digital circuit area;
an active element implemented by an analog circuit and formed in the active element area; and
a passive element implemented by an analog circuit and formed on the device isolation film in the passive element area.

2. The semiconductor integrated circuit device as claimed in claim 1, wherein the semiconductor integrated circuit device is configured such that a reverse bias is applied to a PN junction formed between the first well and the semiconductor substrate and a reverse bias is applied to a PN junction formed between the first well and the second well.

3. The semiconductor integrated circuit device as claimed in claim 2, further comprising:
a highly-doped first-conductivity-type layer having the first conductivity type and formed in the first well at a position away from the digital circuit area,
wherein a supply voltage for the analog circuit is supplied to the highly-doped first-conductivity-type layer.

4. The semiconductor integrated circuit device as claimed in claim 3, further comprising:
highly-doped second-conductivity-type layers having the second conductivity type and formed in the semiconductor substrate and the second well,
wherein a ground voltage for the analog circuit is supplied to the highly-doped second-conductivity-type layers.
